(19) Europäisches Patentamt

European Patent Office

Office européen des brevets

(11) **EP 2 981 120 A1**

(12) **EUROPEAN PATENT APPLICATION**

(43) Date of publication:
03.02.2016 Bulletin 2016/05

(51) Int Cl.:
*H04W 16/20* (2009.01)

(21) Application number: 15174816.7

(22) Date of filing: 01.07.2015

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA

(30) Priority: 30.07.2014 US 201414446758

(71) Applicant: Simmonds Precision Products, Inc.
Vergennes, VT 05491 (US)

(72) Inventors:
• BAJEKAL, Sanjay
Simsbury, CT Connecticut 06070 (US)
• LYNCH, Michael A.
Shelburne, VT Vermont 05482 (US)

(74) Representative: Iceton, Greg James
Dehns
St Bride's House
10 Salisbury Square
London EC4Y 8JD (GB)

(54) **METHODS FOR DEVELOPING WIRELESS NETWORK TOPOLOGIES IN AIRCRAFT**

(57) A method includes receiving an electronic aircraft model (100), wherein the aircraft model (100) represents an aircraft in a constructed state for a plurality of aircraft characteristics. The method also includes determining a transmitter location of at least one transmitting device (101) for the aircraft model and determining at least one transmission characteristic of the at least one transmitting device (101). At least one electromagnetic property of an electromagnetic field (205) emitted by the transmitting device (101) is calculated as a function of at least one of the aircraft characteristics, the transmitter location, or the at least one transmission characteristic. The method also includes determining one or more receiver locations of one or more receivers (103) to provide a system wherein signals from the transmitter device (101) reach at least one of the receiver locations.

Fig. 1

EP 2 981 120 A1

# Description

## BACKGROUND

### 1. Field

The present disclosure relates to wireless networks, more specifically to wireless networks in aircraft.

### 2. Description of Related Art

An aircraft can employ many devices (e.g., sensors, actuators and control systems) that include a communication system. The communication system is capable of transferring information in both directions - (a) from the aircraft computer to the device and (b) from the device to the aircraft computer. The communication system may consist of a wired network, a wireless network or a combination of both, also known as a hybrid network. The wired network can consist of copper wires or optical fiber. The wireless network can consist of electric-field radio frequency (RF), magnetic-field radio frequency and free space optics. In the case of wireless networks, access points (AP) to the wireless network are distributed throughout the aircraft. These AP are intermediary nodes between the aircraft computer and the device. Wireless communications occurs when, for example, a transmitter in a device modulates data on a RF carrier, that is received by a receiver on the AP by means of tuning to the carrier frequency and demodulating the data. Thus wireless communications between the AP and the device depends on receiving signals of sufficient quality to function. However, to determine the amount of receivers needed and the location to place the receivers in the aircraft is an after-the-fact analysis performed using measuring devices in the aircraft after it is constructed. This is a time consuming and expensive empirical process. Also, to retrofit the aircraft with additional transmitting devices requires the process to be repeated to determine if existing receivers are sufficient or if the addition of the new transmitting devices requires additional receivers and/or different placement of existing receivers.

Such conventional methods and systems have generally been considered satisfactory for their intended purpose. However, there is still a need in the art for improved methods to outfit aircraft with wireless communication systems. The present disclosure provides a solution for this need.

## SUMMARY

A method includes receiving an electronic aircraft model, wherein the aircraft model represents an aircraft in a constructed state for a plurality of aircraft characteristics. The method also includes determining a transmitter location of at least one transmitting device for the aircraft model and determining at least one transmission characteristic of the at least one transmitting device.

At least one electromagnetic property of an electromagnetic field emitted by the transmitting device, or at least one optical property of the transmitting device, is calculated as a function of at least one of the aircraft characteristics, the transmitter location, or the at least one transmission characteristic. The method also includes determining one or more receiver locations of one or more receivers to provide a system wherein signals from the transmitter device reach at least one of the receiver locations.

Receiving an electronic aircraft model can further include receiving aircraft characteristics including at least one of a dimension of a portion of the aircraft, a material of the portion of the aircraft, contents of the aircraft and their respective properties, electromagnetic properties, or optical reflection properties of the aircraft and its contents. Determining at least one transmission characteristic can further include determining at least one of a power of the transmitter or a frequency of the signals output by transmitting device.

Calculating at least one electromagnetic property of an electromagnetic field can include determining a field strength as a function of space relative to the transmitting device. Calculating at least one electromagnetic property of an electromagnetic field can include determining signal quality as a function of space relative to the transmitting device. In some embodiments, calculating at least one electromagnetic property of an electromagnetic field can include determining signal interference as a function of space relative to the transmitting device. The method can further include determining a minimum number of receivers and receiver locations needed for a plurality of transmitting devices such that each of the transmitting devices can reach at least one of the receivers.

Calculating optical properties may include diffuse and specular reflections as well as shadowing and reflection effects due to blocking objects, such as overhead bins and seats.

In at least one aspect of this disclosure, a non-transitory computer readable medium can include computer executable instructions, the computer executable instructions including the method and/or portions thereof described herein, along with any other suitable methods/portions thereof.

These and other features of the systems and methods of the subject disclosure will become more readily apparent to those skilled in the art from the following detailed description taken in conjunction with the drawings.

## BRIEF DESCRIPTION OF THE DRAWINGS

So that those skilled in the art to which the subject disclosure appertains will readily understand how to make and use the devices and methods of the subject disclosure without undue experimentation, embodiments thereof will be described by way of example only and in detail herein below with reference to certain figures, wherein:

Fig. 1 is a schematic perspective view of an aircraft model in accordance with this disclosure, showing a plurality of transmitters and receivers modeled therein;

Fig. 2 is a schematic perspective view of the aircraft model of Fig. 1, showing electromagnetic fields emanating from the transmitters disposed therein;

Fig. 3 is a chart depicting network coverage optimization; and

Fig. 4 is a flowchart of an embodiment of a method in accordance with this disclosure.

## DETAILED DESCRIPTION

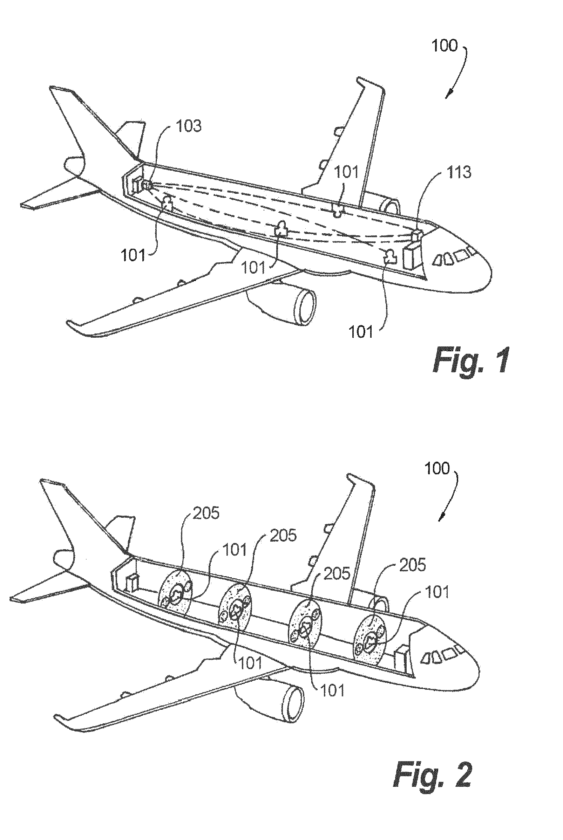

Reference will now be made to the drawings wherein like reference numerals identify similar structural features or aspects of the subject disclosure. For purposes of explanation and illustration, and not limitation, an illustrative view an embodiment of an aircraft model in accordance with the disclosure is shown in Fig. 1, and is designated generally by reference character 100. Other embodiment, or aspects thereof, are shown in Figs. 2-4 as will be described herein. The systems and methods described herein can be used to efficiently and/or retroactively determine suitable wireless receiver locations in an aircraft or other suitable vehicle without the need for empirical testing.

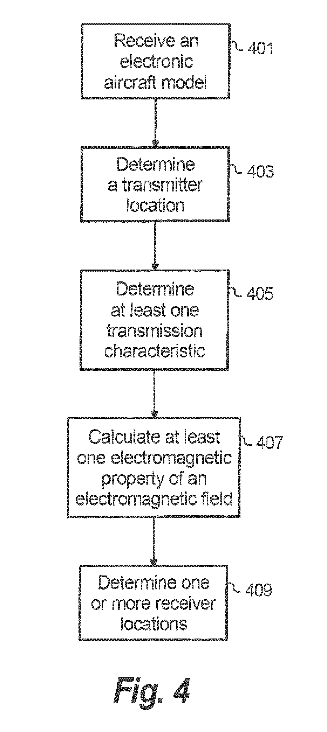

Referring to Figs. 1-4, in at least one aspect of this disclosure, a method 400 includes receiving an electronic aircraft model 100 (e.g., block 401 in Fig. 4), wherein the aircraft model 100 represents an aircraft in a constructed state with a plurality of aircraft characteristics. The aircraft model 100 can be made via any suitable three-dimensional modeling software or any other suitable system. In some embodiments, the aircraft model 100 can be provided by a manufacturer of aircraft.

The aircraft characteristics can include any suitable aircraft characteristics and or characteristics under different circumstances (e.g., with passengers, baggage, etc. thereon). In some embodiments, the aircraft characteristics can include at least one of a dimension of a portion of the aircraft, a material of the portion of the aircraft, contents of the aircraft and their respective properties, electromagnetic properties of the aircraft and its contents, or optical properties of the aircraft and its contents.

Method 400 further includes determining a transmitter location of at least one transmitting device 141 for the aircraft model (e.g., block 403). A plurality of transmitting devices 101 can be placed at any suitable location on the aircraft model, but many times would be located near or on a specific device (e.g., an actuator) that is attached to the aircraft at a known location. Method 400 can also include determining at least one transmission characteristic of the at least one transmitting device 101 (e.g., block 405). In some embodiments, the transmission characteristics can include determining at least one of a power of the transmitter or a frequency of the signals output by transmitting device 101. Any other suitable transmission characteristics are also contemplated herein.

With reference now to Figs. 1 and 2, method 400 further includes calculating at least one electromagnetic property of an electromagnetic field 205 emitted by the transmitting device 101 (e.g., block 407 in Fig. 4) as a function of at least one of the aircraft characteristics, the transmitter location, or the at least one transmission characteristic. Similarly, at least one optical property may be calculated for free space optical transmitting devices. Any suitable physical, statistical/empirical, and/or hybrid mathematical model may be used to calculate the electromagnetic properties of the electromagnetic field 205. The electric field in Newton/Coulombs or volts/meter is given by

$$\vec{E} = \frac{\vec{F}}{q}$$

where, F is the electric force in Newtons and q is the charge in Coulombs. Expressed in the form of Lorentz force law, the above equation becomes:

$$\vec{F} = q\vec{E} + q\vec{v} \times \vec{B}$$

which is the electromagnetic force per unit charge with respect to the frame of charge.

Calculating the field and/or characteristics thereof can include determining a field strength as a function of space relative to the transmitting device 101. In some embodiments, calculating an electromagnetic property of an electromagnetic field can include determining signal quality (e.g., using any suitable criteria to determine signal quality) as a function of space relative to the transmitting device. In some embodiments, calculating an electromagnetic property of an electromagnetic field can include determining signal interference as a function of space relative to the transmitting device.

The method 400 further includes determining one or more receiver locations of one or more receivers 103 (e.g., block 409) to provide a system wherein signals from the transmitter device 101 reaches at least one of the receiver locations. The receivers 103 can be any suitable wireless receiver and are also connected to an aircraft computer. The receivers 103 can be connected to a data concentrator which is then connected to the aircraft computer to provide the aircraft computer with a condensed input of information. Each of the receivers 103 can be connected together in one or more suitable networks.

In embodiments, where multiple transmission devices 101 are employed, the method 400 can further include determining a minimum number of receivers 103 shown in Fig. 1, and receiver locations needed for a plurality of transmitting devices 101 such that each of the transmitting devices 101 can reach at least one of the receivers 103. In this respect, weight, complexity, and cost can be minimized by optimizing the amount of required receivers. Any suitable optimization mathematical model can be employed to achieve this.

For example, there are three primary optimization techniques: (a) algorithms that end after a defined number of process steps, (b) iterative algorithms with the intention of converging to a solution in a reasonable time and (c) heuristic approaches that arrive at a solution based on known rules, where the final solution itself may be suboptimal. Examples of (a) include the Simplex algorithm invented by George Danzig. Examples of (b) include Newton's method and gradient descent method. Examples of (c) include evolutionary algorithms.

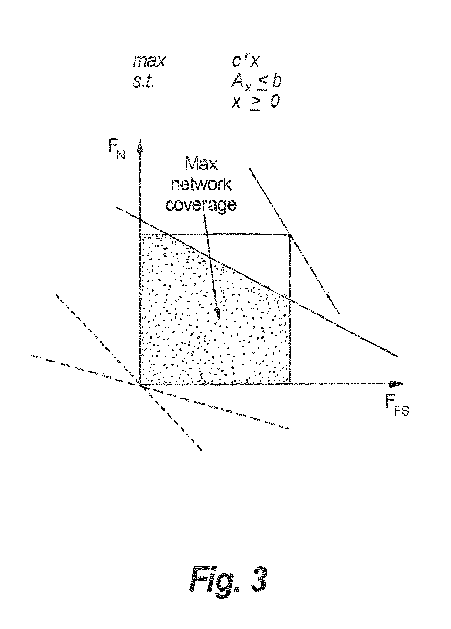

Fig. 3 shows a chart depicting network coverage optimization and a generic description of an optimization problem. For the purposes of this application, $c^T x$ is the objective function, as described here nominally expresses the criteria to be maximized, c being the cost of AP x. Constraints are expressed in the next two equations, $Ax \leq b$ and $x \geq 0$, where the maximal budget for AP is $b$ and the number of AP $(x)$ is greater than 0. The dotted lines in the figure indicate potential vectors for optimization. The $y$-axis function of the number of AP, while the $x$-axis is a physical number of AP. The shaded area in the figure is the region where one of several optimal solutions may exist. In at least one aspect of this disclosure, a nontransitory computer readable medium can include computer executable instructions, the computer executable instructions including the method and/or portions thereof described herein, along with any other suitable methods/portions thereof. The computer executable instructions can take the form of any suitable software code.

The above systems and methods can be used to reduce the resources and time needed to install wireless communication systems on an aircraft. Instead of having to physically enter a constructed aircraft and experimentally determine where receivers 103 should be placed using measurement tools, locations can be determined via the herein disclosed methods such that little or no experimentation is necessary. Moreover, if a transmission device 101 is retrofit to an aircraft, the steps can be used to determine a suitable retrofit location for a new receiver 103/transmission device and/or if the existing receivers 103 are sufficient or if they can be moved to provide sufficient connection.

The methods and systems of the present disclosure, as described above and shown in the drawings, provide for receiver installation methods with superior properties including model based receiver location determination and optimization. While the apparatus and methods of the subject disclosure have been shown and described with reference to embodiments, those skilled in the art will readily appreciate that changes and/or modifications may be made thereto without departing from the scope of the subject disclosure.

**Claims**

1. A method, comprising:

   receiving an electronic aircraft model (100), wherein the aircraft model (100) represents an aircraft in a constructed state for a plurality of aircraft characteristics;
   determining a transmitter location of at least one transmitting device (101) for the aircraft model (100);
   determining at least one transmission characteristic of the at least one transmitting device (101);
   calculating least one electromagnetic property of an electromagnetic field (205) emitted by the transmitting device (101), or at least one optical property of the transmitting device (101), as a function of at least one of the aircraft characteristics, the transmitter location, or the at least one transmission characteristic; and
   determining one or more receiver locations of one or more receivers (103) to provide a system wherein signals from the transmitter device (101) reaches at least one of the receiver locations.

2. The method of claim 1, wherein receiving further includes receiving aircraft characteristics including at least one of a dimension of a portion of the aircraft, a material of the portion of the aircraft, contents of the aircraft and their respective properties, or electromagnetic properties of the aircraft and its contents.

3. The method of claim 1, wherein determining at least one transmission characteristic includes determining at least one of a power of the transmitter or a frequency of the signals output by transmitting device (101).

4. The method of claim 1, wherein calculating at least one electromagnetic property of an electromagnetic field (205) includes determining a field strength as a function of space relative to the transmitting device (101).

5. The method of claim 1, wherein calculating at least one electromagnetic property of an electromagnetic field (205) includes determining signal quality as a function of space relative to the transmitting device (101).

6. The method of claim 1, wherein calculating at least one electromagnetic property of an electromagnetic field (205) includes determining signal interference as a function of space relative to the transmitting device (101).

7. The method of claim 1, further comprising determining a minimum amount of the receivers (103) and the receiver locations for a plurality of transmitting devices (101) such that each of the transmitting devices (101) can reach at least one of the receivers (103).

8. A non-transitory computer readable medium including computer executable instructions, the computer executable instructions comprising:

    receiving an electronic aircraft model (100), wherein the aircraft model (100) represents an aircraft in a constructed state for a plurality of aircraft characteristics;
    determining a transmitter location of at least one transmitting device (101) for the aircraft model (100);
    determining at least one transmission characteristic of the at least one transmitting device (101);
    calculating at least one electromagnetic property of an electromagnetic field (205) emitted by the transmitting device (101), or at least one optical property of the transmitting device (101), as a function of at least one of the aircraft characteristics, the transmitter location, or the at least one transmission characteristic; and
    determining one or more receiver locations of one or more receivers (103) to provide a system wherein signals from the transmitter device reaches at least one of the receiver locations.

9. The non-transitory computer readable medium of claim 8, wherein receiving further includes receiving aircraft characteristics including at least one of a dimension of a portion of the aircraft, a material of the portion of the aircraft, contents of the aircraft and their respective properties, or electromagnetic properties of the aircraft and its contents.

10. The non-transitory computer readable medium of claim 8, wherein determining at least one transmission characteristic includes determining at least one of a power of the transmitter or a frequency of the signals output by transmitting device (101).

11. The non-transitory computer readable medium of claim 8, wherein calculating at least one electromagnetic property of an electromagnetic field (205) includes determining a field strength as a function of space relative to the transmitting device (101).

12. The non-transitory computer readable medium of claim 8, wherein calculating at least one electromagnetic property of an electromagnetic field (205) includes determining signal quality as a function of space relative to the transmitting device (101).

13. The non-transitory computer readable medium of claim 8, wherein calculating at least one electromagnetic property of an electromagnetic field (205) includes determining signal interference as a function of space relative to the transmitting device (101).

14. The non-transitory computer readable medium of claim 8, wherein the computer executable instructions further comprise determining a minimum amount of the receivers (103) and the receiver locations for a plurality of transmitting devices (101) such that each of the transmitting devices can reach at least one of the receivers (103).

Fig. 1

Fig. 2

$$max \quad\quad c^r x$$
$$s.t. \quad\quad A_x \leq b$$
$$x \geq 0$$

Max
network
coverage

$F_N$

$F_{FS}$

*Fig. 3*

Receive an
electronic
aircraft model — 401

Determine
a transmitter
location — 403

Determine
at least one
transmission
characteristic — 405

Calculate at least
one electromagnetic
property of an
electromagnetic field — 407

Determine one
or more receiver
locations — 409

*Fig. 4*

Europäisches
Patentamt

European
Patent Office

Office européen
des brevets

# EUROPEAN SEARCH REPORT

**Application Number**

EP 15 17 4816

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CARL J DEBONO ET AL: "Optimization of the UMTS Network Radio Coverage On-board an Aircraft", 2008 IEEE AEROSPACE CONFERENCE; 1-8 MARCH 2008; BIG SKY; MT, USA, IEEE, PISCATAWAY, NJ, USA, 1 March 2008 (2008-03-01), pages 1-7, XP031256183, ISBN: 978-1-4244-1487-1 * page 1, left-hand column, paragraph 3 - right-hand column, paragraph 2 * * page 2, left-hand column, paragraph 3 - page 4, last paragraph * * page 5, left-hand column, last paragraph - right-hand column, last paragraph * * figures 4, 5 * ----- | 1-14 | INV. H04W16/20 |
| A | RAJO-IGLESIAS EVA ET AL: "Wireless corner: Characterization and consideration of topological impact of wireless propagation in a commercial aircraft environment", IEEE ANTENNAS AND PROPAGATION MAGAZINE, IEEE SERVICE CENTER, PISCATAWAY, NJ, US, vol. 55, no. 6, 1 December 2013 (2013-12-01), pages 240-258, XP011544395, ISSN: 1045-9243, DOI: 10.1109/MAP.2013.6781739 [retrieved on 2014-04-01] * the whole document * * ----- | 1-14 | |
| | | | **TECHNICAL FIELDS SEARCHED (IPC)** |
| | | | H04W |
| | -/-- | | |

The present search report has been drawn up for all claims

| Place of search | Date of completion of the search | Examiner |
|---|---|---|
| The Hague | 11 December 2015 | Behringer, Lutz |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
...................................................................
& : member of the same patent family, corresponding
   document

EPO FORM 1503 03.82 (P04C01)

**Europäisches Patentamt**
**European Patent Office**
**Office européen des brevets**

# EUROPEAN SEARCH REPORT

Application Number

EP 15 17 4816

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KEITH CHETCUTI ET AL: "Wireless propagation modelling inside a business jet", EUROCON 2009, EUROCON '09. IEEE, IEEE, PISCATAWAY, NJ, USA, 18 May 2009 (2009-05-18), pages 1644-1649, XP031492081, ISBN: 978-1-4244-3860-0 * abstract * * page 1646, left-hand column, paragraph 1 - page 1647, left-hand column, paragraph 1 * * page 1647, left-hand column, last paragraph * * figure 3 * ----- | 1-14 | |

TECHNICAL FIELDS
SEARCHED        (IPC)

The present search report has been drawn up for all claims

| Place of search | Date of completion of the search | Examiner |
|---|---|---|
| The Hague | 11 December 2015 | Behringer, Lutz |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................

& : member of the same patent family, corresponding
document

EPO FORM 1503 03.82 (P04C01)